# EUROPÄISCHE PATENTSCHRIFT

(11) **EP 1 890 162 B1**
(45) Veröffentlichungstag und Bekanntmachung des Hinweises auf die Patenterteilung: **25.03.2015**
(21) Anmeldenummer: 07113489.4
(22) Anmeldetag: 31.07.2007
(51) Int. Cl.: G01R 1/20, G01R 31/36, H01R 11/28, H01R 13/66, G01R 31/00

(54) **Elektrische Mess-Vorrichtung**
Electric measuring device
Dispositif de mesure électrique

(30) Priorität: 12.08.2006 DE 102006038373
(43) Veröffentlichungstag der Anmeldung: 20.02.2008
(73) Patentinhaber: ROBERT BOSCH GMBH, 70442 Stuttgart (DE)
(72) Erfinder: Koelle, Gerhard, 75446 Wiernsheim (DE); Mazingue-Desailly, Stephan, 71640 Ludwigsburg (DE); Lerich, Alexander, 71701 Schwieberdingen (DE); Hellwig, Roland, 71679 Asperg (DE)

(56) Entgegenhaltungen:
- EP-A1- 1 204 166
- EP-A1- 1 742 065
- EP-A2- 0 214 532
- EP-A2- 1 286 419
- WO-A1-01/44825
- WO-A1-99/54744
- DE-A1- 10 347 111
- DE-A1-102004 049 153
- DE-A1-102004 053 648
- DE-A1-102005 043 320
- FR-A1- 2 866 158
- US-A1- 2003 017 753
- US-A1- 2006 076 466

## Beschreibung

### Stand der Technik

Offenbarung der Erfindung

Die Erfindung betrifft eine elektrische Vorrichtung, insbesondere eine Vorrichtung zum Ermitteln von elektrischen Größen nach der Gattung des unabhängigen Patentanspruchs. Beispielhaft kann an dieser Stelle die deutsche Offenlegungsschrift DE 10 2004 049 153 angegeben werden. Bei einer derartigen Ausführung ist nachteilig, dass Schwingbelastungen bzw. Zugbelastungen am Hauptleiter zu hohen Werkstoffspannungen im Verbindungsbereich zwischen Hauptleiter und Klemme führen können.

Elektrische Vorrichtungen zum Ermitteln von elektrischen Größen, die eine Verbindungsbereich zwischen einem Sensor und einer Befestigungsstelle zur Befestigung mit einem Batteriepol sind außerdem aus den folgenden Dokumenten bekannt: DE 10 2005 043320 A1, DE 10 2004 053648 A1, FR 2 866 158 A1, EP 1 286 419 A2, EP 1 204 166 A1, WO 99/54744 A1, US 2003/017753 A1, US 2006/076466 A1, WO 01/44825 A1, DE 103 47 111 A1, EP 0 214 532 A2 und EP 1 742 065 A1.

### Vorteile der Erfindung

Die erfindungsgemäße elektrische Vorrichtung, insbesondere Vorrichtung zum Ermitteln von elektrischen Größen, wie beispielsweise ein Batteriesensor, mit den Merkmalen des unabhängigen Anspruchs hat den Vorteil, dass nunmehr Raum geschaffen wird, um eine weitere Befestigungsstelle anzubringen, die somit die Momentenbelastung im Verbindungsbereich zwischen Befestigungsstelle und Leitern deutlich verringern. Die Dauerhaltbarkeit ist verbessert.

Durch die in den Unteransprüchen aufgeführten Maßnahmen sind vorteilhafte Weiterbildungen der elektrischen Vorrichtung nach dem Hauptanspruch möglich. Ist ausgehend von der Grenzfläche jenseits der zentralen Achse ein weiterer Verbindungsbereich vorhanden, der einen der Leiterabschnitte mit der Befestigungsstelle verbindet, so wird dadurch die Befestigung insbesondere des zweiten Leiters und somit die Momentenbelastung in der Grenzfläche deutlich verringert.

Eine einfache Möglichkeit, den zweiten Leiterabschnitt mit der Befestigungsstelle zu verbinden besteht darin, dass ein Formschluss gewählt ist. Ganz besonders gilt das dann, wenn der Formschluss durch ein Formteil hergestellt ist, das beide Leiterabschnitte, nämlich den ersten und den zweiten Leiterabschnitt, umgreift. Günstig ist dabei, wenn das Formteil die Form zweier geschlossener Ringe aufweist, die miteinander verbunden sind (Form einer Acht). Die übertragbaren Haltekräfte sind dabei besonders hoch. Eine sichere Isolation zwischen beiden Leiterabschnitten ergibt sich zusätzlich dann, wenn die Verbindungsstelle, an der beide Ringe verbunden sind, beide Leiterabschnitte voneinander isoliert.

Günstigerweise ist dabei vorgesehen, dass das Formteil ein Teil des Gehäuses und somit ein Gehäuseabschnitt ist.

Werden der erste und der zweite Leiterabschnitt an der Grenzfläche miteinander verbunden bzw. miteinander stoffschlüssig verbunden, so ergibt sich eine gute Fertigbarkeit beider Leiterabschnitte an sich und zusätzlich der Kraftübertragungsstelle zwischen zweitem Leiter und Befestigungsstelle.

### Ausführungsbeispiel

### Zeichnungen

In den Zeichnungen ist ein Ausführungsbeispiel einer erfindungsgemäßen elektrischen Vorrichtung dargestellt. Es zeigen:
Figur 1 einen Längsschnitt durch die elektrische Vorrichtung,
Figur 2 einen Teilschnitt durch die elektrische Vorrichtung aus Figur 1,
Figur 3a, b und c jeweils Teilschnitte durch die elektrische Vorrichtung, wobei hier die Leiterplatte unterschiedliche Positionen einnehmen kann.

### Beschreibung

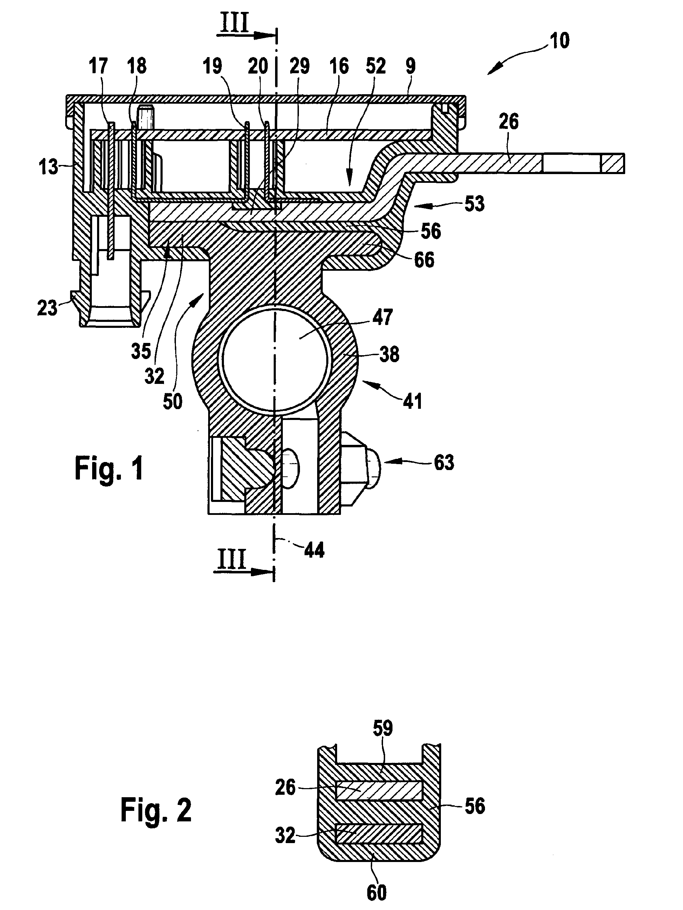

Die Figur 1 zeigt einen Längsschnitt durch die elektrische Vorrichtung 10. Die elektrische Vorrichtung umfasst ein Gehäuse 13, in dem eine Leiterplatte 16 angeordnet ist. Das Gehäuse 13 ist durch einen Deckel 9 verschlossen. Das Gehäuse 13 ist ein Gehäuse aus einem Kunststoff und ist durch Spritzgießen hergestellt. Dieses Gehäuse 13 umschließt mit seinem Werkstoff teilweise verschiedene Gegenstände: So z.B. die verschiedenen Pins 17, 18, 19 und 20. Pin 17 ist dabei ein Pin, der eine Verbindung zur Umgebung des Gehäuses 13 ermöglicht und ist Teil eines Steckers 23. Die Pins 18, 19 und 20 sind mit einem hier als zweiten Leiterabschnitt 26 bezeichneten Leiter verbunden. Mittels dieser Pins 18, 19 und 20 ist es möglich, den so genannten Batteriestrom, der durch den zweiten Leiterabschnitt 26 fließt, zu ermitteln. Hierzu weist der zweite Leiterabschnitt 26 einen so genannten Shunt-Abschnitt 29 auf. Pin 19 und 20 schließen dabei zwischen sich den Shunt-Abschnitt 29 ein, der die übliche Eigenschaft hat, einen besonders konstanten Widerstand bei unterschiedlichen Betriebsbedingungen aufzuweisen. Diese Eigenschaft ermöglicht es, verhältnismäßig genau den Spannungsabfall über den Shunt-Abschnitt 29 zu ermitteln und somit direkt oder indirekt auf den Ladezustand einer angeschlossenen Batterie zu schließen. Der zweite Leiterabschnitt erstreckt sich dabei größtenteils innerhalb des Gehäuses 13. Der zweite Leiterabschnitt 26 ist mit einem ersten Leiterabschnitt 32 verbunden. Diese elektrische Verbindung ist dabei in einer Grenzfläche 35 realisiert. Diese Grenzfläche 35 ist die Übergangsstelle zwischen erstem Leiterabschnitt und zweitem Leiterabschnitt. Der erste Leiterabschnitt kann dabei einstückig mit einer Klemme 38 ausgeführt sein, die Teil einer Befestigungsstelle 41 ist.

In die Befestigungsstelle 41 kann eine zentrale Achse 44 einbeschrieben werden. Ist die Befestigungsstelle 41, wie hier als Klemme 38 ausgeführt, die im Wesentlichen kreisrund ist und auch eine im Wesentlichen runde zentrale Öffnung aufweist, die einen Mittelpunkt 47 hat, so soll diese zentrale Achse 44 durch diesen Mittelpunkt 47 einbeschrieben sein. Des Weiteren soll diese zentrale Achse 44 im Wesentlichen mittig (Flächenschwerpunkt) durch einen Verbindungsbereich 50 hindurch treten. Dieser Verbindungsbereich 50 stellt die Verbindung zwischen dem Gehäuse 13 und der Befestigungsstelle 41 her. Es ist dabei vorgesehen, dass die Grenzfläche 35 von der zentralen Achse 44 versetzt angeordnet ist, Figur 1. Es ist somit eine elektrische Vorrichtung 10 vorgesehen, insbesondere eine Vorrichtung zum Ermitteln von elektrischen Größen, beispielsweise ein Batteriesensor, mit einem Verbindungsbereich 50 zwischen dem Teil der Vorrichtung, der elektrische Größen ermittelt und einer Befestigungsstelle 41. Dabei weist der Verbindungsbereich 50 eine im Wesentlichen zentrale Achse 44 auf. Des Weiteren ist zwischen einem ersten Leiterabschnitt 32 und einem zweiten Leiterabschnitt 26 eine Grenzfläche 35 vorhanden, an der beide Leiterabschnitte miteinander leitfähig verbunden sind. Es ist dabei vorgesehen, dass die Grenzfläche 35 von der zentralen Achse 44 versetzt angeordnet ist. Dies bedeutet, dass die zentrale Achse 44 nicht durch die Grenzfläche 35 hindurch tritt.

Ausgehend von der Grenzfläche 35 befindet sich jenseits der zentralen Achse 44 der weitere Verbindungsbereich 52, der den zweiten Leiterabschnitt 26 mit der Befestigungsstelle 41 verbindet. Dieser zweite Leiterabschnitt 26 ist mit der Befestigungsstelle 41 durch zumindest einen Formschluss 53 verbunden. Dieser Formschluss 53 ist aus einem Formteil 56 hergestellt, das beide Leiterabschnitte 32 und 26 umgreift, siehe auch Figur 2. Der verbindende Bereich des Formteils 56 hat dabei die Form zweier geschlossener Ringe (achtförmig), die miteinander verbunden sind. An der Verbindungsstelle, an der beide Ringe 59 und 60 miteinander verbunden sind, werden die beiden Leiterabschnitte 32 und 26 voneinander isoliert. Das Formteil 56 ist dabei ein Gehäuseabschnitt des Gehäuses 13.

Das Bauteil, das die Befestigungsstelle 41 mit der Klemme 38 sowie dem Leiterabschnitt 32 umfasst, weist eine in etwa hammerartige Gestalt auf. Hammerartig deswegen, weil der Verbindungsbereich 50 und die Klemme 38 sowie der Verspannungsabschnitt 63 praktisch in gerader Linie angeordnet sind, wobei diese gerade Linie durch die bereits erwähnte zentrale Achse 44 repräsentiert ist. Verspannungsabschnitt 63, Befestigungsstelle 41 und Verbindungsbereich 50 stellen im Vergleich mit einem Hammer praktisch den Stiel dar, der an seinem einen Ende in eine Kontur übergeht, die im Wesentlichen dem Eisen eines Hammers entspricht. Dies bedeutet in diesem Fall, dass von dem Verbindungsbereich 50 sich in zwei entgegen gesetzte Richtungen Materialvorsprünge erstrecken. Der eine Materialvorsprung weist die Ganzfläche 35 auf. Der andere als Stummel ausgebildete Materialvorsprung 66 dient dazu, den Formschluss 53 zu ermöglichen.

Die beiden Leiterabschnitte 26 und 32 sind an der Grenzfläche 35 miteinander verbunden. Dabei ist als Verbindungstechnik der Stoffschluss gewählt. Hierfür kommt beispielsweise das Schweißen oder Löten in Frage.

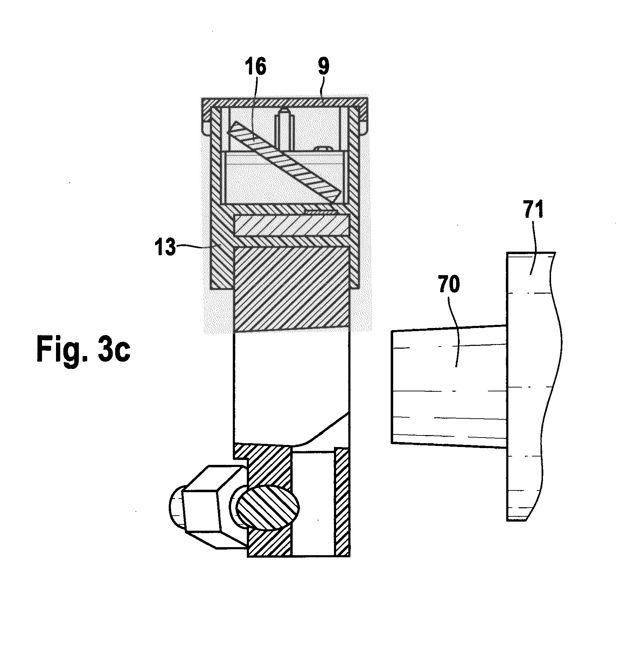

Die Befestigungsstelle 41 dient dazu, die Vorrichtung 10 ortsfest zu halten, wobei diese Befestigungsstelle 41 derartig ausgebildet ist, dass diese dazu geeignet ist, die Vorrichtung 10 an einem üblichen Batteriepol 70 einer Batterie 71 eines Kraftfahrzeugs zu halten. Der übliche Batteriepol 70 weist dabei im Wesentlichen zylindrische oder kegelstumpfförmige Gestalt auf, Figur 3c.

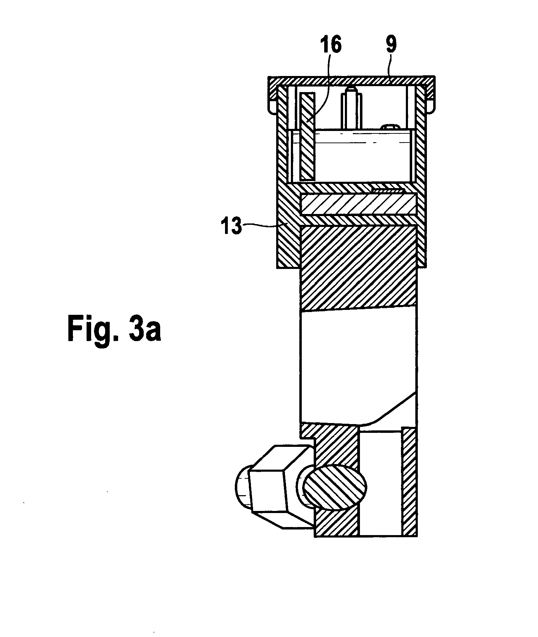

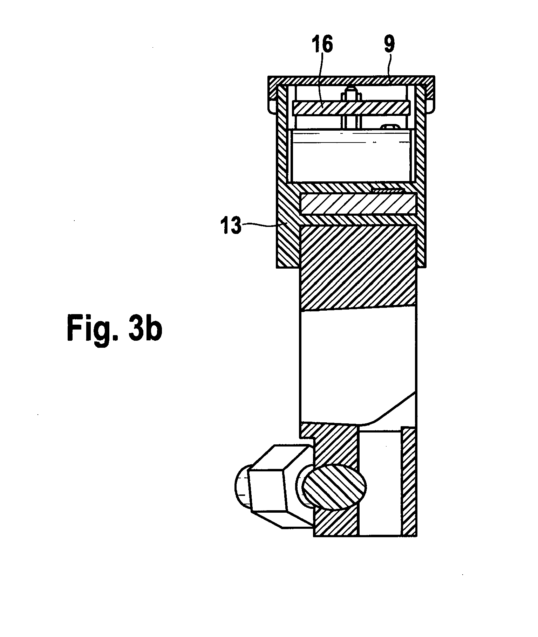

Wie in den Figuren 3a, b und c dargestellt ist, kann die Leiterplatte 16 auf unterschiedliche Art und Weise im Gehäuse 13 positioniert sein. So kann die Leiterplatte 16 beispielsweise senkrecht zu dem Abschnitt des zweiten Leiterabschnitts 26 ausgerichtet sein, der den Shunt-Abschnitt 29 trägt. Wie in Figur 1 und Figur 3b zu sehen ist, kann die Leiterplatte 16 auch parallel zu dem genannten Abschnitt ausgerichtet sein. Falls erforderlich, kann gemäß Figur 3c auch vorgesehen sein, die Leiterplatte 16 schräg im Gehäuseinnenraum anzuordnen.

Das Herstellungsverfahren lässt sich dabei insgesamt wie folgt beschreiben. So werden zunächst der erste Leiterabschnitt 32 und der zweite Leiterabschnitt 26 durch Stoffschluss bzw. ein stoffschlüssiges Verfahren, wie beispielsweise Ultraschallschweißen oder Hartlöten miteinander verbunden. Anschließend werden die Pins 18, 19 und 20 auf dem zweiten Leiterabschnitt 26 befestigt. Im Ausführungsbeispiel werden diese Pins 18 bis 20 durch Schweißen befestigt. Alternative Befestigungsverfahren sind Verlöten oder auch das Einpressen von geraden Pins 18 bis 20 in Öffnungen des zweiten Leiterabschnitts 26. Dabei sind auch andere Ausführungen der Signalleitungen am zweiten Leiterabschnitt 26 möglich. So wäre es z.B. auch denkbar, dass Teile des zweiten Leiterabschnitts 26 umgeformt sind und dann entsprechende Anschlusselemente für die Signalleitungen bilden. Es könnte auch ein Stanzbiegeteil als Anschlusselement des Shunts hergestellt sein. Alle Komponenten, das heißt der erste Leiterabschnitt 32, der zweite Leiterabschnitt 26 sowie die Pins 18, 19 und 20 und auch der zusätzliche Pin 17 werden anschließend mit Kunststoff zu einem Gehäuse 13 zur Aufnahme der Elektronik (Leiterplatte 16) umspritzt. Die Geometrien der Signalleitungen, Steckerleitungen (Pins 17 bis 20) und der zweite Leiterabschnitt 26 erlauben durch ihre Abmessungen und Formgebung ein zum Gehäuseinneren dichtes Umspritzen. Die gehäuseseitigen Enden der Signalleitungen bzw. Pins 17 bis 20 sind für die Verbindung zur Leiterplatte 16 entsprechend ausgeführt, so dass sie nicht nur die elektrische Verbindung zur Leiterplatte bilden, sondern gleichzeitig die mechanische Befestigung der Leiterplatte 16 darstellen. Dabei ist es möglich, dass nicht nur die zwei Signalleitungen (Pins 19 und 20), welche zur Messung der Shunt-Spannung erforderlich sind, ausgeführt sind, sondern es können auf jeder Seite des Shunts 29 mehr als eine Signalleitung ausgeführt sein. Dabei wird mindestens eine dieser mehreren Signalleitungen auf jeder Seite des Shunts zur Messung der Shunt-Spannung genutzt. Ausführungen der Signalleitung auf der Anschlussseite der Elektronik können ausgeführt sein, dass die Sensorleitungen (Pins 17 bis 20) in entsprechende Aussparungen in der Leiterplatte 16 eingepresst oder eingelötet werden. Alternativ könnten die entsprechenden Kontakte auch auf der Leiterplatte aufgelötet oder aufgeschweißt werden. Der Deckel 9, der zum Schutz der Elektronik gegen äußere Einflüsse dient, kann an das Kunststoffgehäuse 13 lasergeschweißt, ultraschallgeschweißt oder auch geklebt sein. Alternativ kann der Deckel 9 auch durch eine Zusatzdichtung und Verrastungsclipse (Schnapphaken) an das Gehäuse 13 befestigt sein.

## Patentansprüche

1. Elektrische Vorrichtung zum Ermitteln von elektrischen Größen, mit einem Verbindungsbereich (50) zwischen dem Teil der Vorrichtung, der elektrische Größen ermittelt und einer Befestigungsstelle (41) zur Befestigung der Vorrichtung mit einem Batteriepol, wobei der Verbindungsbereich (50) eine im Wesentlichen zentrale Achse (44) aufweist, die durch die Befestigungsstelle (41) verläuft, mit einer senkrecht zur zentralen Achse (44) verlaufenden leitfähigen Grenzfläche (35) zwischen zwei Leiterabschnitten (26 und 32), wobei der eine Leiterabschnitt (26) einen Shunt (29) umfasst, und wobei die Grenzfläche (35) von der zentralen Achse (44) versetzt angeordnet ist, so dass die zentrale Achse (44) nicht durch die Grenzfläche (35) hindurch tritt, **dadurch gekennzeichnet, dass** ausgehend von der Grenzfläche (35) jenseits der zentralen Achse (44) ein weiterer Verbindungsbereich (52) vorhanden ist, der den zweiten Leiterabschnitt (26) mit der Befestigungsstelle (41) verbindet, und dass der Leiterabschnitt (26) mit der Befestigungsstelle (41) zumindest durch einen Formschluss (53) verbunden ist, indem ein Formteil (56) vorgesehen ist, das beide Leiterabschnitte (32 und 26) umgreift.

2. Elektrische Vorrichtung nach Anspruch 1, **dadurch gekennzeichnet, dass** das Formteil (56) eine Form zweier geschlossener und miteinander verbundener Ringe (59, 60) aufweist.

3. Elektrische Vorrichtung nach Anspruch 2, **dadurch gekennzeichnet, dass** die Verbindungsstelle, an der beide Ringe (59 und 60) verbunden sind, beide Leiterabschnitte (26 und 32) voneinander isoliert.

4. Elektrische Vorrichtung nach einem der vorhergehenden Ansprüche, **dadurch gekennzeichnet, dass** das Formteil (56) ein Gehäuseabschnitt ist.

5. Elektrische Vorrichtung nach einem der vorhergehenden Ansprüche, **dadurch gekennzeichnet, dass** die zwei Leiterabschnitte (26 und 32) an der Grenzfläche (35) miteinander stoffschlüssig verbunden sind.

6. Elektrische Vorrichtung nach einem der vorhergehenden Ansprüche, **dadurch gekennzeichnet, dass** die Befestigungsstelle (41) dazu dient, die Vorrichtung (10) ortsfest zu halten.

7. Elektrische Vorrichtung nach einem der Ansprüche zuvor, **dadurch gekennzeichnet, dass** die Befestigungsstelle (41) so ausgebildet ist, dass diese dazu geeignet ist, die Vorrichtung an einem üblichen Batteriepol (70) einer Batterie (71) eines Kraftfahrzeugs zu halten.

## Claims

1. Electrical apparatus for determining electrical variables, having a connecting region (50) between the part of the apparatus which detects electrical variables and a fastening point (41) for fastening the apparatus to a battery pole, wherein the connecting region (50) has a substantially central axis (44) which runs through the fastening point (41), having a conductive interface (35), which runs perpendicular to the central axis (44), between two conductor sections (26 and 32), wherein one conductor section (26) comprises a shunt (29), and wherein the interface (35) is arranged in a manner offset from the central axis (44), so that the central axis (44) does not pass through the interface (35), **characterized in that**, starting from the interface (35), a further connecting region (52) is present on the other side of the central axis (44), the said further connecting region connecting the second conductor section (26) to the fastening point (41), and **in that** the conductor section (26) is connected to the fastening point (41) at least by an interlocking connection (53) by a shaped part (56) which engages around the two conductor sections (32 and 26) being provided.

2. Electrical apparatus according to Claim 1, **characterized in that** the shaped part (56) is in the shape of two closed rings (59, 60) which are connected to one another.

3. Electrical apparatus according to Claim 2, **characterized in that** the connecting point at which the two rings (59 and 60) are connected isolates the two conductor sections (26 and 32) from one another.

4. Electrical apparatus according to one of the preceding claims, **characterized in that** the shaped part (56) is a housing section.

5. Electrical apparatus according to one of the preceding claims, **characterized in that** the two conductor sections (26 and 32) are connected to one another in a cohesive manner at the interface (35).

6. Electrical apparatus according to one of the preceding claims, **characterized in that** the fastening point (41) serves to hold the apparatus (10) fixed in position.

7. Electrical apparatus according to one of the claims above, **characterized in that** the fastening point (41) is designed such that it is suitable for holding the apparatus on a conventional battery pole (70) of a battery (71) of a motor vehicle.

## Revendications

1. Dispositif électrique destiné à déterminer des grandeurs électriques et présentant une partie de raccordement (50) entre la partie du dispositif qui détermine les grandeurs électriques et un emplacement de fixation (41) qui fixe le dispositif à un pôle de batterie,
la partie de raccordement (50) comportant un axe (44) essentiellement central qui traverse l'emplacement de fixation (41),
une surface frontière conductrice (35) s'étendant perpendiculairement à l'axe central (44) entre deux parties de conducteur (26 et 32),
une première partie de conducteur (26) comportant un shunt (29),
la surface frontière (35) étant décalée par rapport à l'axe central (44) de telle sorte que l'axe central (44) ne traverse pas la surface frontière (35), **caractérisé en ce que**
partant de la surface frontière (35) et de chaque côté de l'axe central (44) sont prévues d'autres parties de raccordement (52) qui relient la deuxième partie de conducteur (26) à l'emplacement de fixation (41) et
**en ce que** la partie de conducteur (26) est raccordée à l'emplacement de fixation (41) au moins par une correspondance géométrique (53) en prévoyant une partie moulée (56) qui entoure les deux parties (32 et 26) de conducteur.

2. Dispositif électrique selon la revendication 1, **caractérisé en ce que** la pièce moulée (56) présente la forme de deux anneaux (59, 60) fermés et raccordés l'un à l'autre.

3. Dispositif électrique selon la revendication 2, **caractérisé en ce que** l'emplacement de raccordement sur lequel les deux anneaux (59 et 60) sont raccordés, isole l'une de l'autre les deux parties (26 et 32) de conducteur.

4. Dispositif électrique selon l'une des revendications précédentes, **caractérisé en ce que** la pièce moulée (56) est une partie du boîtier.

5. Dispositif électrique selon l'une des revendications précédentes, **caractérisé en ce que** les deux parties conductrices (26 et 32) sont reliées l'une à l'autre en correspondance de matière au niveau de la surface frontière (35).

6. Dispositif électrique selon l'une des revendications précédentes, **caractérisé en ce que** l'emplacement de fixation (41) sert à immobiliser le dispositif (10).

7. Dispositif électrique selon l'une des revendications qui précèdent, **caractérisé en ce que** l'emplacement de fixation (41) est configuré de telle sorte qu'il permette de maintenir le dispositif sur un pôle de batterie habituel (70) de la batterie (71) d'un véhicule automobile.
